# EUROPEAN PATENT APPLICATION

(11) **EP 2 003 677 A2**
(43) Date of publication of application: **17.12.2008**
(21) Application number: 08009106.9
(22) Date of filing: 16.05.2008
(51) Int. Cl.: H01K 9/00

(54) **Filament lamp and light irradiation type heat treatment device**

(30) Priority: 29.05.2007 JP 2007142266; 05.02.2008 JP 2008025142
(71) Applicant: USHIODENKI KABUSHIKI KAISHA, Chiyoda-ku 100 Tokyo (JP)
(72) Inventor: Suzuki, Shinji, Tokyo-to (JP); Mizukawa, Yoichi, Himeji-shi Hyogo-ken (JP)
(74) Representative: Tomerius, Isabel

(57) **Abstract**

To provide a filament lamp and light irradiation type heat treatment device that eliminates device-by-device variation of the irradiation-intensity distribution on the article to be treated, a filament lamp (1) has multiple filament assemblies (41 to 45) with coiled filaments (411 to 451) connected to leads (412a to 452a, 412b to 452b) that supply electrical power to the filaments arranged within a tubular bulb (3), which is formed with hermetic seal areas (2a, 2b), extending along the bulb axis of the bulb, with power being supplied to each filament independently by electrical connection of the leads of the filament assemblies to multiple conductive parts (81a to 85a, 81b to 85b) located in the seal areas, and in which the leads (412a to 452a, 412b to 452b) of the filament assemblies (41 to 45) are inserted through the inside of the filaments (411 to 451).

## Description

### Background of the Invention

### Field of Invention

This invention relates to a filament lamp and to a light irradiation type heat treatment device, and particularly, to a filament lamp used for heat treatment of an article to be treated and a light irradiation type heat treatment device equipped with such a filament lamp.

### Description of Related Art

Heat treatment is used in a variety of processes in the manufacture of semiconductors, including film growth, oxidation, nitriding, film stabilization, silicidation, crystallization, and ion injection activation. In particular, rapid thermal processing (hereafter RTP) of a semiconductor wafer or another article to be treated by quickly raising and lowering its temperature enables improved throughput and quality, and so its use is desirable.

Incandescent lamps, for example, are used as the light source in this type of light irradiation type heat treatment device (simply "heat treatment device" hereafter).

Incandescent lamps have filaments arranged inside bulbs made of a material that is transparent to light, and they radiate 90 % or more of the invested power, so that they can heat an article to be treated without making contact. Therefore, it is possible, when using them as heat sources for heating glass substrates or semiconductor wafers, to raise the temperature of the article to be treated more quickly than by the resistance heating method, specifically, to a temperature of at least 1000 °C in a period from several seconds to several tens of seconds, and also to cool the article to be treated quickly by stopping the light irradiation.

When the article to be treated is, for example, a semiconductor wafer (silicon wafer), if there is unevenness of the temperature distribution of the semiconductor wafer when it is heated to a temperature of 1050 °C or higher, a phenomenon called "slip," in which crystal transition defects arise and quality declines, is liable to occur in the semiconductor wafer. For this reason, it becomes necessary to heat the semiconductor wafer, hold it at a high temperature, and then cool it so that the temperature distribution will be even across the entire surface. In other words, highly precise uniformity of temperature of the article to be treated is sought in RTP.

Even in the event that the light irradiation is performed so that the degree of irradiation is uniform across the entire surface of the semiconductor wafer for semiconductor wafers that have the same physical characteristics, the temperature distribution of the semiconductor wafer will not be uniform; the temperature at the edges of the semiconductor wafer will be lower. That is, because heat will be radiated by the side surfaces of the semiconductor wafer. As a result of this heat release, there will be unevenness in the temperature distribution of the semiconductor wafer. When the semiconductor wafer is heated to 1050 °C or higher, as noted above, slip will occur in the semiconductor wafer if there is unevenness in the semiconductor wafer temperature distribution.

Accordingly, it is desirable to compensate for the temperature drop due to heat radiation from the sides of the semiconductor wafer and thus even out the temperature distribution in the semiconductor wafer by means of light irradiation such that the surface at the edges of the semiconductor wafer is irradiated to a greater degree than the surface at the center of the semiconductor wafer.

As for conventional heat treatment device, Japanese Pre-grant Patent Report H7-37833 of 1995 (JP '833) discloses heat treatment device that uses incandescent lamps to heat a glass substrate or semiconductor wafer.

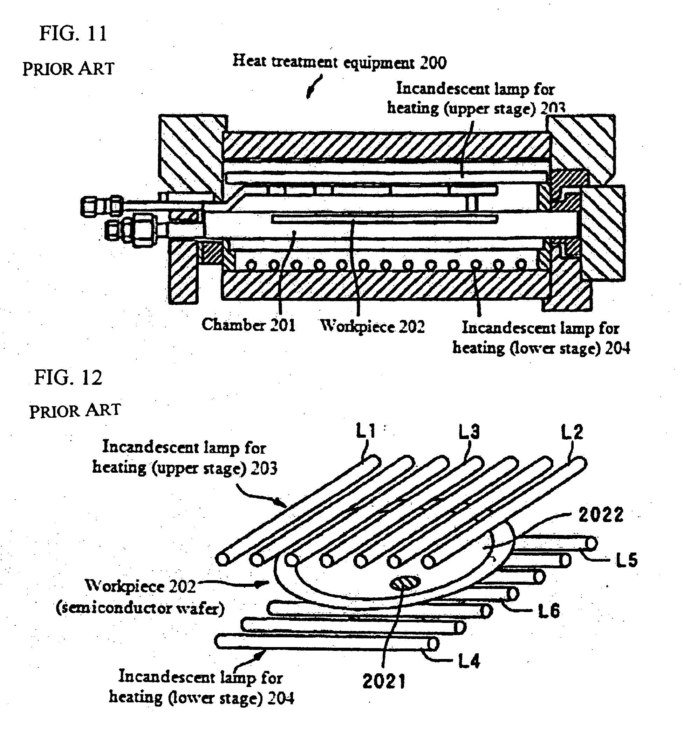

Figure 11 is a cross section of heat treatment device 200 with the conventional technology described in JP '833. As shown in this figure, this heat treatment device 200 is constituted such that an article 202 to be treated is accommodated in a chamber 201 made of light-transparent material, with two stages of multiple incandescent lamps 203, 204 for heating outside the chamber 201, facing from above and below, with axes that cross. Both surfaces of the article 202 to be treated are heated by means of light irradiation from the incandescent lamps of lamp stages 203, 204.

Figure 12 is a perspective view that simplifies the heat treatment device shown in Figure 11 and extracts the upper and lower lamp stages 203, 204 and the article 202 to be treated. As shown in the figures, the upper and lower incandescent lamp stages 203, 204 are placed with the lamp bulb axes crossing and so it is possible to heat the article 202 to be treated uniformly. Using this equipment, moreover, it is possible to prevent the reduction of temperature due to the action of heat radiation from the edges of the article 202 to be treated. For example, the lamp output of the incandescent lamps for heating L1, L2 at the ends of the stage above the article 202 to be treated is set higher than the lamp output of the incandescent lamp for heating L3 at the center, and the lamp output of the incandescent lamps for heating L4, L5 at the ends of the stage below the article 202 to be treated is set higher than the lamp output of the incandescent lamp for heating L6 at the center. It is possible, by this means, to compensate for the reduction of temperature due to the action of heat radiation from the article 202 to be treated, to minimize the temperature difference between the center and edges of the article 202 to be treated, and thus to make the temperature distribution of the article 202 to be treated uniform.

However, it has been learned that the problem described below may occur in the conventional heat treatment device described above. Specifically, in the case that the article 202 to be treated is a semiconductor wafer, for example, it is common to form a film of metal oxide or other material on the surface of a semiconductor wafer by the sputtering method and then to dope it with impurities by means of ion implantation; the film thickness of such a metal oxide and the density of the impurity ions will have a localized distribution on the surface of the semiconductor wafer. This localized distribution will not necessarily have central symmetry with respect to the center of the semiconductor wafer. Taking the density of the impurity ions as an example, sometimes there is a difference, as shown in Figure 12, between the density of the impurity ions in a small, special region 2021 that does not have central symmetry with respect to the center of the semiconductor wafer and the other region 2022. Even if such a special region 2021 and the other region 2022 are irradiated to have the same irradiation intensity, there may be a difference in the speed of temperature rise between the special region 2021 and the other region 2022, and the temperature of the special region 2021 and the temperature of the other region 2022 will not necessarily be the same.

Using the conventional heat treatment device 200 described above, it is relatively easy to compensate for the temperature drop at the edges of the article 202 to be treated due to heat radiation and prevent reduction of the temperature at the edges, and to make the temperature distribution of the article 202 to be treated uniform. Nevertheless, for a small, special region 2021 on the semiconductor wafer with a total length that is shorter than the wavelength of light emitted by the lamp, as shown in Figure 12, in the event of light irradiation suited to the properties of the special region 2021, there will also be light irradiation of the region 2022 outside the special region 2021. And so, it is not possible to control the temperature state so that it is suited both to the special region 2021 and to the other region 2022. That is, it is not possible to control the irradiation of the small, special region 2021 so that the temperature of the two is uniform. Therefore, there is the problem of an undesirable temperature distribution in the treatment temperature of the article 202 to be treated, and it becomes difficult to apply the desired physical properties to the article 202 to be treated.

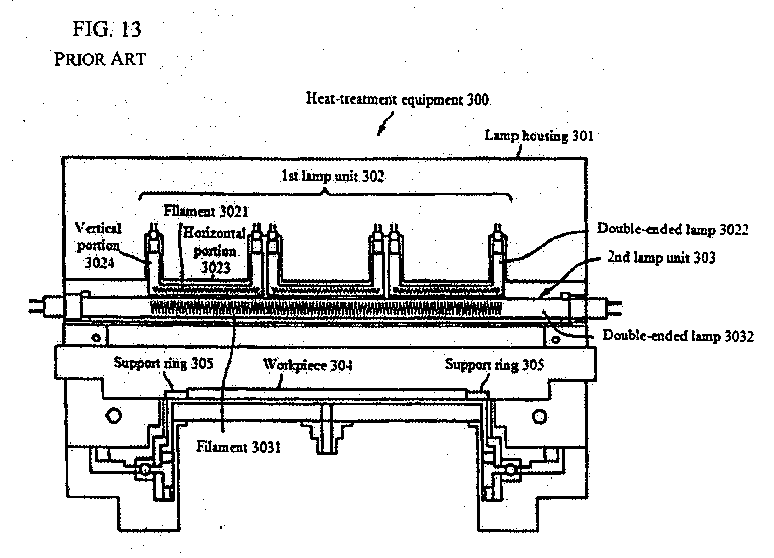

Figure 13 is a cross section of the heat treatment device 300 described in Japanese Pre-grant Patent Publication 2002-203804 and corresponding U.S. Patent 6,876,816. As shown in this figure, this heat treatment device 300 has, within a lamp housing 301, a first lamp unit 302 that has an array of multiple U-shaped, double-ended lamps 3022 with equipment at both ends of the bulbs to supply power to the filaments 3021, arrayed parallel to and perpendicular to the plane of the paper, and a second lamp unit 303 located below the first lamp unit 302, having an array of multiple straight-line, double-ended lamps 3032 with equipment at both ends of the bulbs to supply power to the filaments 3031, running along and perpendicular to the plane of the paper; they provide heat treatment of an article 304 to be treated that is placed below the second lamp unit 303.

The portions of the article 304 to be treated that are in contact with the supporting ring 305, which supports the article 304 to be treated, tend to have a lower temperature than other portions; Japanese Pre-grant Patent Publication 2002-203804 and corresponding U.S. Patent 6,876,816 describe a mechanism to control those U-shaped lamps belonging to the first lamp unit 302 that are positioned above the portions in contact to have a higher power, in order to raise the temperature of the portions in contact. Further, patent Japanese Pre-grant Patent Publication 2002-203804 and corresponding U.S. Patent 6,876,816 describe the use of this heat treatment device 300 as outlined below.

First, the semiconductor wafer that is the article 304 to be treated is divided into multiple concentric zones with central symmetry. Then, by combining the irradiation patterns of the individual lamps of the first and second lamp units 302, 303, a combined irradiation distribution pattern that corresponds to those zones and that has central symmetry relative to the center of the semiconductor wafer is formed, and heating is done in response to the temperature changes of each zone. At that time, the semiconductor wafer that is the article 304 to be treated is rotated to suppress the effect of variation in the intensity of light from the lamps. That is, zones located concentrically can be heated at individual illumination intensities.

Accordingly, the heat treatment device 300 described in Japanese Pre-grant Patent Publication 2002-203804 and corresponding U.S. Patent 6,876,816 is capable of producing a temperature in narrow special regions on the article 304 to be treated as long as those regions have central symmetry with respect to the center of the semiconductor wafer. Nevertheless, in the event that the special regions do not have central symmetry with respect to the center of the semiconductor wafer, it is not possible to solve the problem described above properly because heat treatment is done by rotating the semiconductor wafer.

Moreover, it is thought that the following problems could occur if this heat treatment device 300 were actually used. Specifically, a U-shaped lamp comprises a horizontal portion 3023 and a pair of vertical portions 3024, but because only the horizontal portion 3023 where the filament 3021 is located contributes to light emission, the individual lamps are separated by spaces to a degree that cannot be ignored, and so it is conceivable that temperature distributions will occur in areas beneath the spaces.

That is, even though the illumination-intensity distributions of the lamps of the first and second lamp units 302, 303 of the heat treatment device 300 are combined to form a synthesized illumination-intensity distribution with central symmetry on the semiconductor wafer, the illumination intensity beneath the spaces mentioned above will change (drop) rapidly, and so even though heating is done in response to the temperature changes in each zone, it will conceivably be relatively difficult to reduce the temperature distribution that occurs in the vicinities beneath the spaces.
Furthermore, with regard to this sort of heat treatment device 300, there has been a trend in recent years to reduce space (primarily in the height direction) for laying out the lamp units as much as possible, and so if U-shaped lamps are used, space will be needed for the vertical portions 3024 of the lamps; this is not desirable from the perspective of space reduction.

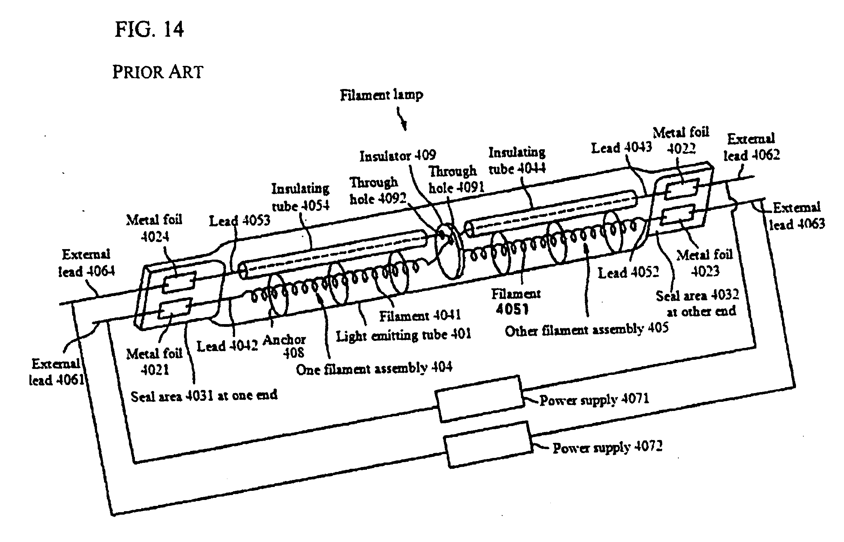

In view of that situation, the present inventors proposed a filament lamp as described in Japanese Pre-grant Patent Publication 2006-279008 and U.S. Patent Application Publication 2006-197454 to be used as the light source of light irradiation type heat treatment device with the following constitution. Figure 14 is a perspective explanatory view of a conventional filament lamp 400 shown in Japanese Pre-grant Patent Publication 2006-279008 and U.S. Patent Application Publication 2006-197454, that the present inventors proposed to resolve the problems described above. This filament lamp 400 is constructed as outlined below. Both ends of the bulb 401 of the filament lamp 400 are formed with hermetic seal areas 4031, 4032 in which are embedded metal foils 4021 to 4024. Within the bulb 401 are multiple (two are shown in figure 14) filament assemblies 404, 405, comprising filaments 4041, 4051 and leads 4042 to 4043, 4052 to 4053 that supply power to the filaments 4041, 4051. Here, when the filament assemblies 404, 405 are placed in the bulb 401, they are orderly arranged so that the filaments 4041, 4051 extend along the length of the bulb 401.

In one filament assembly 404, the lead 4042 that is connected to one end of the filament 4041 is electrically connected to the metal foil 4021 that is embedded in the seal area 4031 at one end of the bulb 401. Further, the lead 4043 that is connected to the other end of the filament 4041 in the filament assembly 404 is threaded through the through hole 4091 of insulator 409; it is covered by an insulating tube 4044 in the area that faces the filament 4051 of the other filament 405, and it is electrically connected to the metal foil 4023 that is embedded in the seal area 4032 at the other end of the bulb 401. Similarly, in the other filament assembly 405, the lead 4052 that is connected to one end of the filament 4051 is electrically connected to the metal foil 4023 that is embedded in the seal area 4032 at one end of the bulb 401. Further, the lead 4053 that is connected to the other end of the filament 4051 in the filament assembly 405 is threaded through the through hole 4092 of insulator 409; it is covered by an insulating tube 4054 in the area that faces the filament 4041 of the one filament 404, and it is electrically connected to the metal foil 4024 that is embedded in the seal area 4031 at the other end of the bulb 401.

The ends of the metal foils 4021 to 4024 embedded in the seal portions 4031, 4032 that are opposite the ends connected to the leads 4042 to 4043, 4052 to 4053 of the filament assemblies 404, 405 are connected to external leads 4061 to 4064 that project from the seal areas 4031, 4032. Accordingly, each filament assembly 404, 405 is connected to two external leads 4061 to 4062, 4063 to 4064 by way of the metal foils 4021 to 4022, 4023 to 4024. Power supplies 4071, 4072 are connected to the filaments 4041, 4051 by way of the external leads 4061 to 4062, 4063 to 4064. It is possible, by this means, to supply power individually to the filaments 4041, 4051 of the filament assemblies 404, 405 of the filament lamp 400.

Now, each filament 4041, 4051 is supported, so that it does not contact the bulb 401, by circular anchors 408 that are sandwiched between the inner wall of the bulb 401 and the insulating tubes 4044, 4054. Here, if there were contact between the filaments 4041, 4051 and the inner wall of the bulb 401 while the filament was emitting light, the light transmissivity of the bulb 401 where the contact occurs would be impaired because of a loss of transparency of the bulb 401 due to heat from the filaments 4041, 4051. The purpose of the anchors 408 is to prevent this problem. Multiple anchors 408 are placed along the length of the bulb 401 for each filament 4041, 4051. Further, the anchors 408 have a degree of flexibility so that the multiple filament assemblies 404, 405 can be easily inserted into the bulb 401 when the filament lamp 400 is produced. Further, a slight gap is left between the anchors 408 and the space between the inner wall of the bulb 401 and the insulating tubes 4044, 4054.

This filament lamp 400 has multiple filaments 4041, 4051 within the bulb 401 and is constituted to provide individual control of the light emitted by each filament 4041, 4051. If such filament lamps 400 are arrayed in parallel and used as a light source in light irradiation type heat treatment device, it is possible to arrange filaments with higher precision with respect to the regions to be irradiated on the article to be treated that was possible using conventional filament lamps having a single filament in the bulb, by aligning the filaments in parallel rows.

Accordingly, by means of light irradiation type heat treatment device using such filament lamps, it is possible to supply power individually to the multiple filaments, and so it is possible to irradiate with the desired irradiation distribution according to the characteristics of the article to be treated, even when the distribution of localized temperature variations on the article to be treated to receive heat treatment is non-symmetrical with respect to the article to be treated. Therefore, the article to be treated can be heated evenly even when the distribution of localized temperature variations on the article to be treated to receive heat treatment is non-symmetrical with respect to the article to be treated, and an even temperature distribution can be achieved across the entire irradiated surface of the article to be treated.

Furthermore, when compared with the heat treatment device 70 that has U-shaped lamps described in JP H7-37833, for example, these filament lamps can have a straight-line shape and so do not require the space corresponding to the vertical portion of U-shaped lamps, and so it is possible to reduce the size of the heat treatment device.

### Summary of the Invention

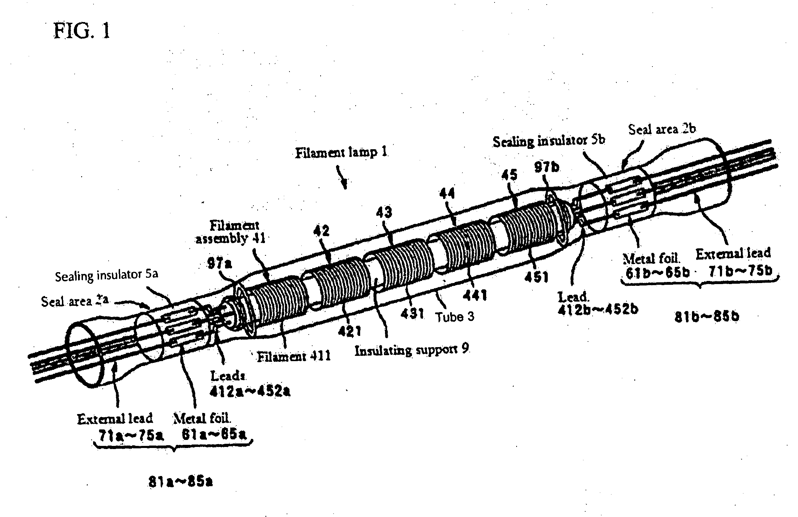

The present inventors, following the construction shown in Figure 1 of Japanese Pre-grant Patent Publication 2006-279008 and U.S. Patent Application Publication 2006-197454, fabricated multiple pieces of light irradiation type heat treatment device having the same specifications and using the filament lamps shown in Figure 14, and operated the multiple pieces of light irradiation type heat treatment device under the same operating conditions. "The same specifications" here means that each piece of light irradiation type heat treatment device had the same numbers of filament assemblies located in the filament lamps and the same numbers of filament lamps located in the lamp units. Moreover, the same placement of filament lamps in each lamp unit was used in the light irradiation type heat treatment device having the same specifications. "The same operating conditions" here means that the power input to the filament lamps located in the lamp units was the same and the atmosphere in which the article to be treated were located (such as the type of gas and gas pressure, for example) were the same in each piece of light irradiation type heat treatment device.

Using the light irradiation type heat treatment device in which are mounted the filament lamps shown in Figure 14, it is possible to make the irradiation-intensity distribution on the article to be treated have a desired distribution by individually controlling the power supplied to each filament. Consequently, it should be possible, by operating pieces of light irradiation type heat treatment device with the same specifications under the same operating conditions, to have the same irradiation-intensity distribution on each article to be treated that undergoes heat treatment in these pieces of light irradiation type heat treatment device.

However, in reality, there was the problem that variation occurred in the irradiation-intensity distributions on articles to be treated that undergo heat treatment in different pieces of light irradiation type heat treatment device. This problem was particularly marked in light irradiation type heat treatment devices in which filament lamps with numerous filament assemblies within each bulb had been mounted in order to realize highly precise control of temperatures on the articles to be treated.

The major cause of this problem is thought to be as follows. There has been a demand in recent years to control the temperatures on the article to be treated with high precision, and as more filaments have been located in the bulb to respond to this demand there has been an increase, relative to the prior art, in the number of leads located inside the bulb. Further, there has been demand to increase the power to the filament lamps in order to heat the semiconductor wafer or another article to be treated more rapidly, or in other words, to increase the power per unit length invested in the filament. Accompanying demands of this sort, it has been necessary to run large currents through the filaments, and so the outside diameters of the leads, relative to the prior art, are being increased so that, when lighted, the leads would not achieve high temperatures, generate heat, and melt through. Because of this situation, there is an increased probability, relative to the prior art, that light emitted by the filament will be obstructed by leads located in the bulb.

In such filament lamps, moreover, individual leads have been covered by insulating tubes so that there will be no short circuits between the multiple leads located in the bulb; it is thought that the use of such insulating tubes is also related to the occurrence of the problem described above. In other words, while the filament lamp is lit, it comes about that the insulating tube reaches a very high temperature because it is irradiated by the light emitted by the filament, and so that the insulating tube generates light. It is thought that when such a situation occurs, it is the same as if there were a new light emitting body in a location other than that of the filament and there is an increased possibility of an adverse effect on the irradiation-intensity distribution on the article to be treated.

In view of the problem described above, a primary object of this invention is to provide a filament lamp and light irradiation type heat treatment device that eliminates device-by-device variation of the irradiation-intensity distribution on the article to be treated.

The above problem is solved by a filament lamp a claimed in claim 1 and a light irradiation type heat treatment device as claimed in claim 4. Preferred embodiments are described in the dependent claims.

This invention adopts the following means to resolve the problem described above. The first means is a filament lamp having multiple filament assemblies, each comprising a coiled filament connected to leads that supply electrical power to the filament, in a linear arrangement within a tubular bulb, which is formed with a hermetic seal area on at least one end, extending along the bulb axis of the bulb, with power being supplied to each filament independently by means of electrical connection of the leads of the filament assemblies to multiple conductive parts located in the seal area, in which leads of individual filament assemblies are inserted through the inside of the coiled filaments.

The second means is a filament lamp as described in the first means, in which an insulating support that extends along the central axis of the filament is located within the coiled filament, and multiple passages through which the leads of the filament assemblies are inserted are formed in the insulating support.

The third means is a filament lamp as described in the first or second means, in which a rod-shaped sealing insulator is located in the hermetic seal area, multiple conductive parts are arrayed at intervals on the periphery of the sealing insulator, and the bulb and the sealing insulator are hermetically sealed with conductive parts between them.

The fourth means is light irradiation type heat treatment device fitted with a light source in which is located a filament lamp as described in any one of the first, second, or third means, the article to be treated being heated by irradiation of the article to be treated with light from that light source.

The fifth means is light irradiation type heat treatment device fitted with a lamp unit in which are arrayed multiple filament lamps as described in any one of the first, second, or third means, the article to be treated being heated by irradiation of the article to be treated with light from that lamp unit.

Using the invention, the leads of the individual filament assemblies are located inside the filaments, and so it is possible to achieve the desired light irradiation intensity distribution without the light emitted by the filaments being blocked by the leads, even when multiple filament assemblies are located in the bulb, since the leads are not located outside the filaments.

Furthermore, even if the insulating support located inside the filaments is irradiated by light from the lighted filaments and reaches a high temperature, most of the light the insulating support emits will be blocked by the filaments and will not reach outside the lamp, and so it will not affect the irradiation-intensity distribution. Also, any light emitted by the insulating support that escapes through gaps in the coils of the filaments is light emitted from within the filaments, and so it can be considered as optically equivalent to light actually emitted by the filaments; it is not liable to have an adverse effect on the light irradiation-intensity distribution.

Additionally, a rod-shaped sealing insulator is installed in the seal area and multiple conductive parts are arrayed at intervals on the periphery of that sealing insulator and hermetically sealed between the bulb and the sealing insulator. Therefore, even if multiple filament assemblies are located within the bulb, in order to allow highly precise control of temperatures on the article to be treated, it is possible to reduce the size of the seal area without short circuits between the multiple conductive parts.

Still further, it is possible, by using filament lamps as described herein and lamp units with such filament lamps, to realize a light irradiation type heat treatment device that eliminates device-by-device variation of the irradiation-intensity distribution on the article to be treated.

### Brief Description of the Drawings

Fig. 1 is an oblique view showing the construction of a filament lamp in accordance with a first embodiment of the invention.

Fig. 2 is a partial perspective view showing the construction of the light emitting area comprising the filament assemblies and the insulating support of the filament lamp 1 shown in figure 1.

Fig. 3 is a partial cross section showing the construction of the light emitting area comprising the filament assemblies and the insulating support of the filament lamp taken along line A-A' in Figure 2.

Fig. 4 is a partial cross section showing a first modification of the construction of the light emitting area shown in Figure 3.

Figs. 5(a) & 5(b) are partial elevational and partial cross-sectional views, respectively, showing a second modification of the construction of the light emitting area shown in Figure 3.

Figs. 6(a) & 6(b) are partial perspective and partial cross-sectional view, respectively, showing another modification of the construction of the light emitting area shown in figure 3.

Fig. 7 is a perspective view showing the construction of the light emitting area comprising the filament assemblies and the insulating support of the filament lamp of a second embodiment of the invention.

Fig. 8 is a perspective view showing the construction of the light emitting area comprising the filament assemblies and the insulating support of the filament lamp of a third embodiment of the invention.

Fig. 9 is a schematic front cross-sectional view showing the light irradiation type heat-treatment device of a fourth embodiment of the invention.

Fig. 10 is a plan view showing the first and second lamp units shown in Figure 9.

Fig. 11 is a cross-sectional view of a conventional heat treatment apparatus.

Fig. 12 is a perspective view showing, in simplified form, the incandescent heating lamps in the upper and lower stages of the heat treatment apparatus of Figure 11.

Fig. 13 is a cross-sectional view of a known heat treatment device.

Fig. 14 is a perspective view of a filament lamp that the present inventors proposed in a prior application.

### Detailed Description of the Invention

The first embodiment of this invention is explained using Figs. 1-6.

As shown in Fig. 1, the filament lamp 1 has a linear or other tubular bulb 3, made of quartz glass or another light-transparent material, and formed with seal areas 2a, 2b at both ends. Within the bulb 3 are sealed a halogen gas and five, for example, filament assemblies 41, 42, 43, 44, 45, the filament assemblies 41, 42, 43, 44, 45 having coiled filaments 411, 421, 431, 441, 451 linearly arranged extending along the bulb axis, outside of an insulating support 9. The filament assemblies 41, 42, 43, 44, 45 comprise filaments 411, 421, 431, 441, 451 connected at both ends to power supply leads 412a, 422a, 432a, 442a, 452a and 412b, 422b, 432b, 442b, 452b that supply power to filaments assemblies 41, 42, 43, 44, 45; their number can be adjusted as appropriate to the dimensions and physical characteristics of the article to be treated. Further, the insulating support 9 is supported within the bulb 3 by insulating support supporting rings 97a, 97b, which are fixed to the insulating support 9 as a single piece, pressing against the inner wall of the bulb 3.

Rod-shaped sealing insulators 5a, 5b made of quartz glass are located inside the bulb 3 near both ends. On the peripheral surface of sealing insulator 5a (5b), five metal foils 61a, 62a, 63a, 64a, 65a (61b, 62b, 63b, 64b, 65b) are lined up parallel to each other in the direction of the length of the sealing insulator 5a (5b) at approximately equal intervals. To avoid twisting, the length of each of the metal foils 61a, 62a, 63a, 64a, 65a (61b, 62b, 63b, 64b, 65b) is shorter than the full length of the sealing insulator 5a (5b). The number of metal foils is greater or lesser depending on the number of filament assemblies 41, 42, 43, 44, 45 within the bulb 3; ordinarily it is double the number of filament assemblies 41, 42, 43, 44, 45. A hermetically sealed seal area 2a (2b) is formed by using a burner or other means to heat outside of the bulb 3 at the place where the sealing insulator 5a (5b) is located, with the metal foils 61a, 62a, 63a, 64a, 65a (61b, 62b, 63b, 64b, 65b) in between the bulb 3 and the sealing insulator 5a (5b).

Because the outer diameter of the sealing insulator 5a is less than the inner diameter of the bulb 3, the bulb 3 is constricted in the area adhered to the sealing insulator 5a (5b), that is, in the seal area 2a (2b). The leads 412a, 422a, 432a, 442a, 452a (412b, 422b, 432b, 442b, 452b) of the filament assemblies 41, 42, 43, 44, 45 are electrically connected, by way of the metal foils 61a, 62a, 63a, 64a, 65a (61b, 62b, 63b, 64b, 65b) in the seal area 2a (2b), to the external leads 71a, 72a, 73a, 74a, 75a (71b, 72b, 73b, 74b, 75b) that project and extend outward from the bulb 3 in the direction of the bulb axis. Each of the external leads 71a, 72a, 73a, 74a, 75a (71b, 72b, 73b, 74b, 75b) is connected to an unillustrated power supply device that feeds power to each of the filaments 411, 421, 431, 441, 451 independently.

When the seal area 2a (2b) is formed by installing a sealing insulator 5a (5b) within the bulb 3 in this way, then even in the case of a filament lamp 1 having numerous conductive parts 81a, 82a, 83a, 84a, 85a (81b, 82b, 83b, 84b, 85) within the bulb 3 because of the multiple filament assemblies 41, 42, 43, 44, 45, it is possible to make use of the peripheral surface of the cylindrical sealing insulator 5a (5b) to lay out numerous metal foils 61a, 62a, 63a, 64a, 65a (61b, 62b, 63b, 64b, 65b) so that they do not contact each other, and so enlargement of the seal area 2a (2b) can be suppressed. Particularly in comparison with a flat seal area 2a (2b) formed by pinch-sealing, the size of the seal area 2a (2b) can be reduced even when numerous conductive parts 81a, 82a, 83a, 84a, 85a (81b, 82b, 83b, 84b, 85) are installed; this is desirable from the perspective of saving space. Now, if it is possible in terms of their dimensions, the metal foils 61a, 62a, 63a, 64a, 65a (61b, 62b, 63b, 64b, 65b) need not be placed at equal intervals, but can be placed at adjusted intervals to correspond to the position of leads located to allow the light from the filament lamp 1 to irradiate most efficiently.

Each of the filament assemblies 41, 42, 43, 44, 45 is supported within the bulb 3 by a circular anchor (illustration of which has been omitted) that is fixed as a single piece to the filament assembly 41, 42, 43, 44, 45 and that presses against the inner wall of the bulb 3. Installing the anchors makes it possible to avoid contact between the inner wall of the bulb 3 and the filaments 411, 421, 431, 441, 451 that reach a high temperature when lighted, and so it is possible to avoid the inconvenience of loss of transparency of the bulb 3 that would be caused by contact with the hot filaments 411, 421, 431, 441, 451.

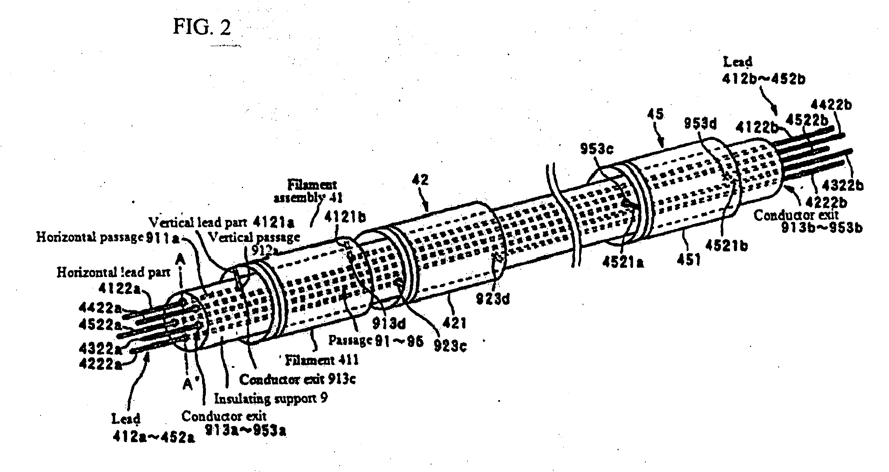

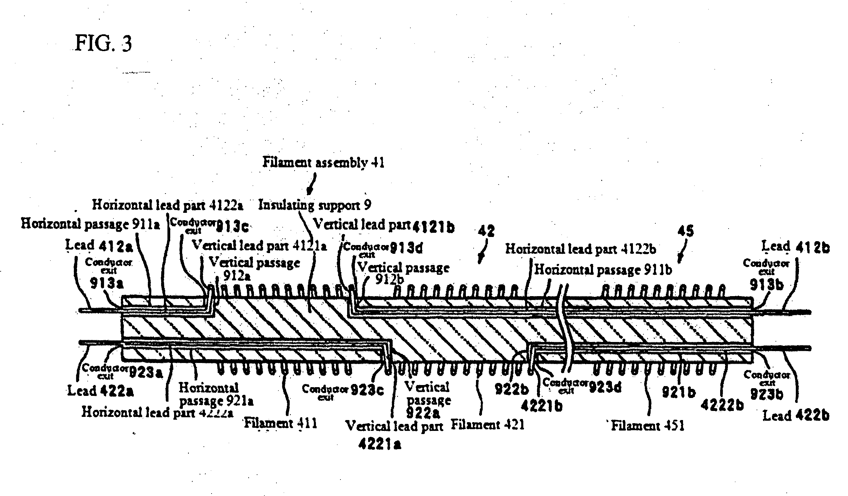

Fig. 2 is a partial perspective view that shows the construction of the light emitting area that comprises the filaments 411, 421, 431, 441, 451 and the insulating support 9 of the filament lamp 1 shown in Fig. 1. Fig. 3 is a partial cross section showing the construction of the light emitting area comprising the filament assemblies 41, 42, 43, 44, and 45 and the insulating support 9, cut in the direction of the bulb axis of the filament lamp 1 at line A-A' in Fig. 2.

As shown in these figures, the filament lamp 1 has the leads 412a, 422a, 432a, 442a, 452a and 412b, 422b, 432b, 442b, 452b of the multiple filament assemblies 41, 42, 43, 44, 45 located within the bulb 3 and supported by the insulating support 9. The insulating support 9, which is made of an insulating material, such as quartz glass, for example, is placed so that it extends along the direction of the bulb axis and penetrates all five coiled filaments 411, 421, 431, 441, 451 that are lined up in the direction of the bulb axis and its central axis matches the central axes of the filaments 411, 421, 431, 441, 451. Within the insulating support 9, passages 91, 92, 93, 94, 95, through which pass the leads 412a, 422a, 432a, 442a, 452a and 412b, 422b, 432b, 442b, 452b, are placed in accordance with the number of leads 412a, 422a, 432a, 442a, 452a and 412b, 422b, 432b, 442b, 452b; the passages 91, 92, 93, 94, 95 extend along the bulb axis parallel to each other and connect with conductor exits 913a, 923a, 933a, 943a, 953a and 913b, 923b, 933b, 943b, 953b at the same circumference on the end faces.

To explain in detail, the multiple passages 91, 92, 93, 94, 95 formed in the insulating support 9 comprise horizontal passages 911a, 921a, 931 a, 941a, 951 a that extend along the bulb axis and connect with the conductor exits 913a, 923a, 933a, 943a, 953a formed in an end face of the insulating support 9, and 913b, 923b, 933b, 943b, 953b; vertical passages 912a, 922a, 932a, 942a, 952a that connect with and bend perpendicular to the horizontal passages 911a, 921a, 931a, 941a, 951a and that connect with the conductor exits 913c, 923c, 933c, 943c, 953c on the lateral surface of the insulating support 9; horizontal passages 911b, 921b, 931b, 941b, 951b that connect with conductor exits 913b, 923b, 933b, 943b, 953b; and vertical passages 912b, 922b, 932b, 942b, 952b that connect with and bend perpendicular to the horizontal passages 911 b, 921 b, 931 b, 941 b, 951 b and that connect with the conductor exits 913d, 923d, 933d, 943d, 953d on the lateral surface of the insulating support 9. Thus, these horizontal passages and vertical passages form "L" shapes if seen in cross section in the insulating support 9. The multiple passages 91, 92, 93, 94, 95 have vertical passages 912a, 922a, 932a, 942a, 952a and vertical passages 912b, 922b, 932b, 942b, 952b facing along from the bulb axis, spaced at distances corresponding to the lengths of the filaments 411, 421, 431, 441, 451.

In Fig. 2, the insulating support 9 has five pairs of passages 91, 92, 93, 94, 95 in opposite directions and conductor exits 913a, 923a, 933a, 943a, 953a and conductor exits 913b, 923b, 933b, 943b, 953b formed at the same circumference on the end faces; five pairs of conductor exits-that is, conductor exits 913c, 923c, 933c, 943c, 953c and conductor exits 913d, 923d, 933d, 943d, 953d-are formed on the lateral surface. Now, it is preferable that the conductor exits 913a, 923a, 933a, 943a, 953a and the conductor exits 913b, 923b, 933b, 943b, 953b be positioned at the same circumference on the end faces of the insulating support 9 so that the leads 412, 422, 432, 442, 452 can be lead out of the insulating support 9 without short circuiting.

This insulating support 9 is formed with multiple passages 91, 92, 93, 94, 95 for the leads 412, 422, 432, 442, 452 by machining a rod of insulating material such as quartz glass, for example, or filling a mold with a molten fluid such as molten quartz glass, then cooling the molten fluid.

The filament assemblies 41, 42, 43, 44, 45 supported by the insulating support 9 comprise hook-shaped leads 412a, 422a, 432a, 442a, 452a at one end that are made up of vertical lead parts 4121 a, 4221a, 4321a, 4421a, 4521a that connect to one end of the filaments 411, 421, 431, 441, 451 and extend in a direction perpendicular to the bulb axis and horizontal lead parts 4122a, 4222a, 4322a, 4422a, 4522a that connect to the vertical lead parts 4121a, 4221a, 4321a, 4421a, 4521a and extend in the direction of the bulb axis; and hook-shaped leads 412b, 422b, 432b, 442b, 452b at the other end that are made up of vertical lead parts 4121b, 4221b, 4321b, 4421b, 4521b that connect to the other end of the filaments 411, 421, 431, 441, 451 and extend in a direction perpendicular to the bulb axis and horizontal lead parts 4122b, 4222b, 4322b, 4422b, 4522b that connect to the vertical lead parts 4121b, 4221b, 4321b, 4421b, 4521b and extend in the direction of the bulb axis.

The filament assemblies 41, 42, 43, 44, 45 are installed in the insulating support 9 in the following manner, with filaments 411, 421, 431, 441, 451 located along the axis of the insulating support 9. For the leads 412a, 422a, 432a, 442a, 452a, at one end, the tips of the horizontal lead parts 4122a, 4222a, 4322a, 4422a, 4522a are inserted into the conductor exits 913c, 923c, 933c, 943c, 953c on the lateral surface of the insulating support 9 so that the tips of the horizontal lead parts 4122a, 4222a, 4322a, 4422a, 4522a project out of the insulating support 9 through the conductor exits 913a, 923a, 933a, 943a, 953a in one end face of the insulating support 9, and the tips of the vertical lead parts 4121a, 4221a, 4321a, 4421a, 4521a project out of the insulating support 9 from the conductor exits 913c, 923c, 933c, 943c, 953c in the lateral surface of the insulating support 9.

Similarly, to install the leads 412b, 422b, 432b, 442b, 452b at the other end, the tips of the horizontal lead parts 4122b, 4222b, 4322b, 4422b, 4522b are inserted into the conductor exits 913d, 923d, 933d, 943d, 953d on the lateral surface of the insulating support 9 so that the tips of the horizontal lead parts 4122b, 4222b, 4322b, 4422b, 4522b project out of the insulating support 9 through of the conductor exits 913b, 923b, 933b, 943b, 953b in the other end face of the insulating support 9, and the tips of the vertical lead parts 4121b, 422 1 b, 4321b, 4421b, 4521b project out of the insulating support 9 from the conductor exits 913d, 923d, 933d, 943d, 953d in the lateral surface of the insulating support 9.

Installation of the filament assemblies 41, 42, 43, 44, 45 in the insulating support 9 is not restricted to the method described above of installing filament assemblies 41, 42, 43, 44, 45 constituted by preparatory connection of leads 412a, 422a, 432a, 442a, 452a and leads 412b, 422b, 432b, 442b, 452b to both ends of the filaments 411, 421, 431, 441, 451; it is also possible to use the method of connecting the leads 412a, 422a, 432a, 442a, 452a and the leads 412b, 422b, 432b, 442b, 452b to both ends of the filaments 411, 421, 431, 441, 451 after the filaments 411, 421, 431, 441, 451 and the leads 412a, 422a, 432a, 442a, 452a and the leads 412b, 422b, 432b, 442b, 452b have been individually put in place with respect to the insulating support 9.

If the wire diameter of the filaments 411, 421, 431, 441, 451 is less than ϕ 0.5 mm and relatively flexible, it is acceptable to form the filaments 411, 421, 431, 441, 451, the vertical lead parts 4121a, 4221a, 4321a, 4421a, 4521a, 4121b, 4221b, 4321b, 4421b, 4521b, and the horizontal lead parts 4122a, 4222a, 4322a, 4422a, 4522a, 4122b, 4222b, 4322b, 4422b, 4522b of single pieces of wire with no connecting joints, and install them by inserting the horizontal lead parts 4122a, 4222a, 4322a, 4422a, 4522a into the conductor exits 913c, 923c, 933c, 943c, 953c on the lateral surface of the insulating support 9 and inserting the horizontal lead parts 4122b, 4222b, 4322b, 4422b, 4522b into the conductor exits 913d, 923d, 933d, 943d, 953d on the lateral surface of the insulating support 9.

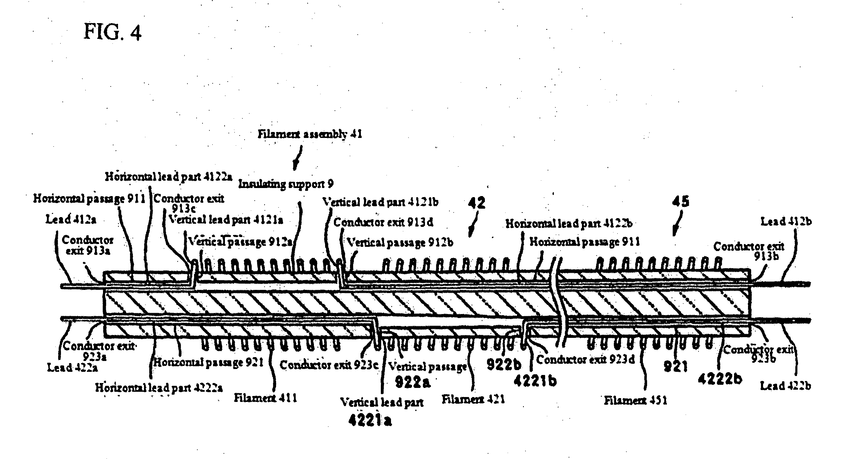

Fig. 4 is a partial cross section showing the construction of the light emitting area comprising the filament assemblies 41, 42, 43, 44, and 45 and an insulating support 9 which differs from the construction of the light emitting area comprising the filament assemblies 41, 42, 43, 44, and 45 and the insulating support 9 shown in Fig. 3.

The light emitting area shown in Fig. 4 differs in the point that instead of the horizontal passages 911 a, 911 b, horizontal passages 921a, 921 b, horizontal passages 931 a, 931b, horizontal passages 941a, 941b, and horizontal passage 951a, 951b shown in Fig. 3, there is a single horizontal passage 911, horizontal passage 921, horizontal passage 931, horizontal passage 941, and horizontal passage 951. When forming single through holes 911, 921, 931, 941, 951 in this way, it is possible to produce the horizontal passages 911 921, 931, 941, 951 by methods that are inexpensive and well-suited to mass production, such as drawing or injection molding. As a result, it is possible to greatly reduce the cost and time required for machining, and thus to reduce production costs. The cost-cutting effect is particularly marked in the case of long lamps in which the length of the insulating support 9 exceeds 200 mm.

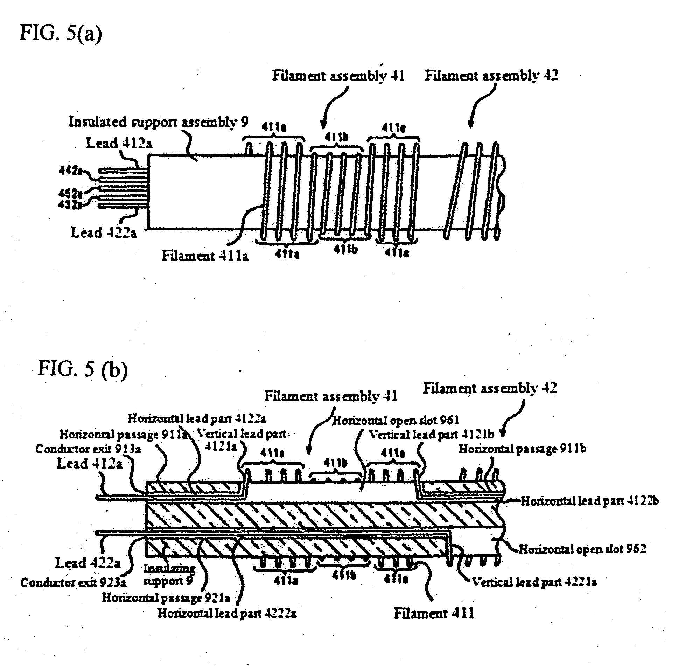

Fig. 5(a) is a partial front view showing the construction of the light emitting area comprising the filament assemblies 41, 42 (filaments 43, 44, and 45 are not illustrated) and the insulating support 9 which differs from the construction of the light emitting area comprising the filament assemblies 41, 42, 43, 44, and 45 and the insulating support shown in Fig. 3. Fig. 5(b) is a partial cross section showing the construction of the light emitting area comprising the filament assemblies 41, 42 (filaments 43, 44, and 45 are not illustrated) and the insulating support 9 which differs from the construction of the light emitting area comprising the filament assemblies 41, 42, 43, 44, and 45 and the insulating support 9 shown in Fig. 3.

As shown in these figures, the insulating support 9 comprises horizontal passages 911 a, 921a (horizontal passages 931 a, 941a, 951a are not illustrated) that connect with conductor exits 913a, 923a (conductor exits 933a, 943a, 953a are not illustrated) that extend along the bulb axis and are formed in one end face of the insulating support 9; horizontal open slots 961, 962 (horizontal open slots 963, 964, 965 are not illustrated) that are formed in the lateral surface of the insulating support 9, extend along the bulb axis, and open in a direction perpendicular to the bulb axis, and that connect with the horizontal passages 911a, 921a (horizontal passages 931 a, 941 a, 951 a are not illustrated); a horizontal passage 911b (horizontal passages 921 b, 931 b, 941 b, 951 b are not illustrated) that extends along the bulb axis and connects with the horizontal open slots 961 (horizontal open slots 963, 964, 965 are not illustrated); and unillustrated conductor exits 913b, 923b, 933b, 943b, 953b that are formed in the other end face of the insulating support 9 and connect with the horizontal passage 911 b (horizontal passages 921 b, 931 b, 941 b, 951 b are not illustrated). This insulating support 9 is formed with multiple passages for insertion of the leads by machining a rod of insulating material, such as quartz glass, for example, or filling a mold with a molten fluid such as molten quartz glass, then cooling the molten fluid.

In the filament assemblies 41, 42 (filament assemblies 43, 44, 45 are not illustrated), the filament 411 (filaments 421, 431, 441, 451 are not illustrated) comprises filaments 411a, 411b, with filament 411b wound around the insulating support 9, and so the filaments 411 a can be supported without contacting the insulating support 9. Now, the other, unillustrated, filaments 421, 431, 441, 451, like the filament 411, comprise filaments 421a, 421 b, filaments 431 a, 431 b, filaments 441 a, 441 b, filaments 451 a, 451 b.

Taking filament 411 as an example for explanation of filaments 411, 421, 431, 441, 451, the filament assemblies 41, 42, 43, 44, 45 are placed on the insulating support 9 and concentric with it, and are attached in the following way. One lead 412a is installed when the tip of the horizontal lead part 4122a is inserted by way of the horizontal open slot 961 in the lateral surface of the insulating support 9, and the tip of the horizontal lead part 4122a is caused to project outside the insulating support 9 from the conductor exit 913a on one end face of the insulating support 9, and the tip of the vertical lead part 4121a projecting from the insulating support 9 from the horizontal open slot 961. In the same way, the other lead 412b is installed when the tip of the horizontal lead part 4122b is inserted by way of the horizontal open slot 961 in the lateral surface of the insulating support 9 and the tip of the horizontal lead part 4122b is caused to project outside the insulating support 9 from the conductor exit 913b on the other end face of the insulating support 9, with the tip of the vertical lead part 4121b projecting from the insulating support 9 from the horizontal open slot 961. When attaching the filament assembly 41 to the insulating support 9, the work of attachment is facilitated by insertion of the horizontal lead parts 4122a, 4122b through the horizontal open slot 961.

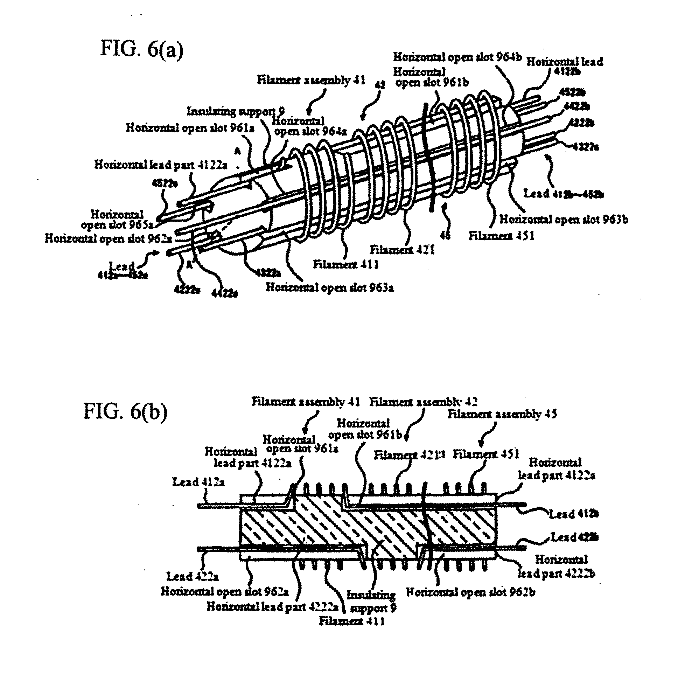

Fig. 6(a) is a partial perspective view showing the construction of the light emitting area comprising the filament assemblies 41, 42, 43, 44, and 45 and the insulating support 9 which differs from the construction of the light emitting area comprising the filament assemblies 41, 42 (filament assemblies 43, 44, and 45 are not illustrated) and the insulating support 9 shown in figure 3. Fig. 6(b) is a partial cross section, taken at line A-A' of Fig. 6(a), showing the construction of the light emitting area comprising the filament assemblies 41, 42, and 45 (filament assemblies 43, 44 are not illustrated) and the insulating support 9.

As shown in these figures, horizontal open slots 961a, 962a, 963a, 964a, 965a that open in a direction perpendicular to the bulb axis and extend along the bulb axis from one end face of the insulating support 9 to the points on the insulating support 9 that support the filaments 411, 421, 451 (filaments 431, 441 are not illustrated) and horizontal open slots 961b, 963b, 964b (horizontal open slots 962b, 965b are not illustrated) that open in a direction perpendicular to the bulb axis and extend along the bulb axis from the other end face of the insulating support 9 to the points on the insulating support 9 that support the filaments 411, 421, 451 (filaments 431, 441 are not illustrated) are formed in the insulating support 9. Such an insulating support 9 is, for example, prepared by cutting of a rod-like material consisting of an insulating material, such as quartz glass or the like, or by cooling of a melt, such as molten quartz glass or the like, poured into a casting mold.

Taking filament 411 as an example for explanation of filaments 411, 421, 431, 441,451, the filament assemblies 41, 42, 43, 44, 45 are placed on the insulating support 9 and concentric with it, and are attached in the following way. One lead 412a is installed by placing the horizontal lead part 4122a in the horizontal open slot 961a that is formed in the lateral surface of the insulating support 9. In the same way, the other lead 412b is installed by placing the horizontal lead part 4122b in the horizontal open slot 961b that is formed in the lateral surface of the insulating support 9. When attaching the filament 411 to the insulating support 9, the work of attachment is facilitated by insertion of the horizontal lead parts 4122a, 4122b of the filament assembly 41 in the open horizontal open slots 961a, 961b.

Now, the horizontal open slot 961a and horizontal open slot 961b described above are individual slots that are not connected, but it is also acceptable to form the horizontal open slot 961a and the horizontal open slot 961b as a single, connected, horizontal open slot if the horizontal lead part 4122a and the horizontal lead part 4122b fix the filament 411 with enough strength that it does not slip along the bulb axis. In this case, it becomes possible to use a die and produce the slots using the drawing method, and thus to cut machining costs.

An example of the specific specifications of the filament lamp 1 of the invention of this embodiment is given below.

The bulb 3 has an outside diameter of about 6 mm to 40 mm and a length from several tens of millimeters to 800 mm; these are decided on the basis of the size of the article to be treated, the distance from the filament lamp 1 to the article to be treated, and the position of the lamp within the lamp unit. The filament assemblies 41, 42, 43, 44, 45 use wire with a diameter of about 0.05 mm to 1 mm. As an actual example, in the event that a silicon wafer of 300 mm diameter is irradiated at a distance of 50 mm, a bulb with an outside diameter of 28 mm and a length of 560 mm and a filament wire with a diameter of 0.5 mm is used. A single filament has a length of 140 mm and is formed with an outside diameter of 8 mm; connected at both ends are leads with a diameter greater than that of the filament wire, of 0.8 mm, for example. The outside diameter of the filament is not limited to 8 mm, but the outside diameter may be from about 4 mm to about 20 mm, depending on the required power and the filament temperature. The maximum rated power per filament is determined in accordance with the required temperature-rise characteristics of the article to be treated and the permissible current value of the metal foils 61, 62, 63, 64, 65 in the seal areas; in this embodiment it is 25 A. The outside diameter of the insulating support 9 is determined on the basis of the inside diameter of the filaments and the number of filaments, and is from 2 mm to about 18 mm; the length is set longer than the total of the lengths of the filaments, and at a length which will fit inside the bulb 3. In this embodiment, it is made from a quartz glass rod with an outside diameter of 3.5 mm and a length of 460 mm. The diameter of the passages 91, 92, 93, 94, 95 is larger than the diameter of the leads 412, 422, 432, 442, 452 so that the leads 412, 422, 432, 442, 452 will pass through, being 1 mm, for example.

The filament lamp 1 of this embodiment of the invention, as stated above, is designed to feed power independently to the multiple filaments 411, 421, 431, 441, 451, by way of the conductive parts 81a, 82a, 83a, 84a, 85a and the conductive parts 81b, 82b, 83b, 84b, 85b located in the seal areas 2a, 2b, and so it is possible to heat the article to be treated uniformly, even in the event of an asymmetrical distribution of degrees of localized temperature change on the article to be treated that is to undergo heat treatment, and so it is possible to realize a uniform temperature distribution across the entire article to be treated.

Moreover, the insulating support 9 located within the filaments 411, 421, 431, 441, 451 supports-in the case of an insulating support 9 located within the filament 411, for example-the leads 422, 432, 442, 452 of the filaments 421, 431, 441, 451 other than filament 411 without short circuits among them, and so even with a construction in which multiple filament assemblies 41, 42, 43, 44, 45 are located within the bulb 3, the leads 412, 422, 432, 442, 452 are not located outside the filaments 411, 421, 431, 441, 451 and so while it is easy to assure insulation between the leads 412, 422, 432, 442, 452, the light emitted by the filaments 411, 421, 431, 441, 451 is not blocked by the leads 412, 422, 432, 442, 452, and it is possible to anticipate the result that the desired light irradiation-intensity distribution can be achieved.

Moreover, even if the insulating support 9 located inside the filaments 411, 421, 431, 441, 451 reaches a high temperature and emits light because of irradiation with light from the lighted filaments 411, 421, 431, 441, 451, it will have no effect on the irradiation-intensity distribution because most of the light it emits will be blocked by the filaments 411, 421, 431, 441, 451 and will not leave the lamp. Further, light radiated from the insulating support 9 that does pass through gaps in the coils of the filaments 411, 421, 431, 441, 451 is light from within the filaments 411, 421, 431, 441, 451, or in other words, light from the center, and so optically it can be considered as substantially equivalent to light emitted by the filaments 411, 421, 431, 441, 451; therefore, it is not liable to have an adverse affect on the light irradiation-intensity distribution.

Because the effects described above can be anticipated from the construction of the filament lamp 1 of the invention of this embodiment, it is particularly effective when there is a goal of rapidly heating the article to be treated and controlling the temperature with good precision. In more detail, the construction of this invention is particularly effective when four or more filament assemblies having leads with an diameter of 0.8 mm are located in the bulb 3 so as to withstand a current as large as 25 A per filament.

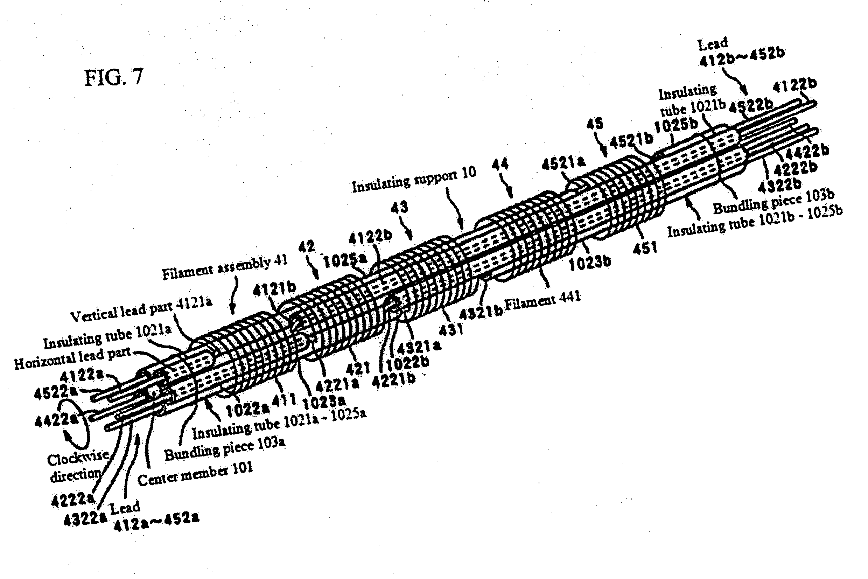

The second embodiment of this invention is explained next using Fig. 7.

Fig. 7 is a perspective view showing the construction of the light emitting area comprising the filament assemblies 41, 42, 43, 44, and 45 and the insulating support 9 of the filament lamp 1 of this embodiment of the invention. The filament lamp 1 of this embodiment of the invention becomes possible by means of applying a light emitting area comprising the filament assemblies and insulating support shown in Fig. 7 in place of the light emitting area comprising the filament assemblies and insulating support shown in Fig. 1.

As shown in Fig. 7, the light emitting area that comprises the filament assemblies 41, 42, 43, 44, 45 and the insulating support 10 of the filament lamp 1 has the same construction as shown in Fig. 2 except for the use of an insulating support that is formed of multiple insulating tubes 1021a, 1022a, 1023a, 1024a, 1025a and insulating tubes 1021b, 1022b, 1023b, 1024b, 1025b, which extend along the bulb axis, and are located on the same circumference around a center member 101 that extends along the bulb axis. The insulating support 10 comprises the center member 101 that extends along the bulb axis and multiple insulating tubes 1021a, 1022a, 1023a, 1024a, 1025a and insulating tubes 1021b, 1022b, 1023b, 1024b, 1025b that extend along the bulb axis. The center member 101 is made of quartz glass or a ceramic, such as alumina, or a metal with a high melting point, such as tungsten or molybdenum, and the multiple insulating tubes 1021a, 1022a, 1023a, 1024a, 1025a, 1021b, 1022b, 1023b, 1024b, 1025b are made of quartz glass or a ceramic, such as alumina. In this embodiment, quartz glass is used for both.

To explain in detail, the insulating support 10 has five pairs of insulating tubes 1021a, 1022a, 1023a, 1024a, 1025a and insulating tubes 1021b, 1022b, 1023b, 1024b, 1025b (that is, a total of ten insulating tubes) of differing lengths arranged on the lateral surface of the center member 101 in the direction of the bulb axis, as follows. In other words, each of the first set of five insulating tubes 1021a, 1022a, 1023a, 1024a, 1025a is located on the lateral surface of the center member 101, extending in the direction of the bulb axis parallel to the center member 101, with its end in the same plane as the end face of the center member 101 and positioned at the same circumference as the others, and is fixed to the center member 101 by a ring-shaped bundling piece 103a that is wrapped around in contact with the lateral surface of each of the five. Similarly, each of the second of five insulating tubes 1021b, 1022b, 1023b, 1024b, 1025b is located on the lateral surface of the center member 101, extending in the direction of the bulb axis parallel to the center member 101, with its end in the same plane as the end face of the center member 101 and positioned at the same circumference as the others, and is fixed to the center member 101 by a ring-shaped bundling piece 103b that is wrapped around in contact with the lateral surface of each of the five.

Moreover, the ten insulating tubes located on the lateral surface of the center member 101 are placed so that the insulating tubes 1021a, 1022a, 1023a, 1024a, 1025a of the first set face the insulating tubes 1021b, 1022b, 1023b, 1024b, 1025b of the second set across gaps (in the areas where the filaments are located) of lengths corresponding to the lengths of the filaments 411, 421, 431, 441, 451, and so that the sums of the lengths of the facing insulating tubes 1021a, 1022a, 1023a, 1024a, 1025a of the first set and insulating tubes 1021b, 1022b, 1023b, 1024b, 1025b of the second set are equal. In other words, taking the insulating tube positioned this side of the surface of the paper as a starting point and moving clockwise around the insulating support 10, the length of the insulating tube 1021a that is the shortest in the first set and the length of the insulating tube 1021 b that is the longest in the second set, the length of the insulating tube 1022a that is the second shortest in the first set and the length of the insulating tube 1022b that is the longest in the second set, the length of the insulating tube 1023a that is the mid-most in the first set and the length of the insulating tube 1023b that is the mid-most in the second set, the length of the insulating tube 1024a that is the second longest in the first set and the length of the insulating tube 1024b that is the second shortest in the second set, and the length of the insulating tube 1025a that is the longest in the first set and the length of the insulating tube 1025b that is the shortest in the second set, in that order, face each other in the direction of the bulb axis across gaps that correspond to the lengths of the filaments 411,421,431,441,451.

In this way, the insulating support 10, which is ten insulating tubes 1021a, 1022a, 1023a, 1024a, 1025a, 1021b, 1022b, 1023b, 1024b, 1025b located on the lateral surface of the center member 101, is formed so that the five filament locations that comprise gaps between the pairs of insulating tubes that face in the direction of the bulb axis are lined up in order in the direction of the bulb axis.

Now in Fig. 7, the first set of five insulating tubes 1021a, 1022a, 1023a, 1024a, 1025a of different lengths are located on the lateral surface of the center member 101 in order of increasing length, taking the insulating tube positioned this side of the surface of the paper as a starting point and moving clockwise around the insulating support 10, but the insulating support 10 is not necessarily limited to that constitution. To the contrary, it is acceptable if the first set of five insulating tubes 1021a, 1022a, 1023a, 1024a, 1025a of different lengths are located on the lateral surface of the center member 101 in order of decreasing length, taking the insulating tube positioned this side of the surface of the paper as a starting point and moving clockwise around the insulating support 10. Moreover, it is possible to constitute the insulating support 10 of multiple insulating tubes alone, with no center member 101.

Like those shown in Figs. 2-5, the filament assemblies 41, 42, 43, 44, 45 use hook-shaped leads 412a, 422a, 432a, 442a, 452a, 412b, 422b, 432b, 442b, 452b that comprise horizontal lead parts 4122a, 4222a, 4322a, 4422a, 4522a, 4122b, 4222b, 4322b, 4422b, 4522b and vertical lead parts 4121a, 4221a, 4321a, 4421a, 4521a, 4121b, 4221b, 4321b, 4421b, 4521b. With the center member 101 of the insulating support 10 in place concentric with the filaments 411, 421, 431, 441, 451, the filament assemblies 41, 42, 43, 44, 45 are installed on the insulating support 10 in the following manner, and are supported by the insulating support 10 so that there are no short circuits.

To explain in detail, for the leads 412a, 422a, 432a, 442a, 452a connected to one end of the filaments 411, 421, 431, 441, 451, the tips of the horizontal lead parts 4122a, 4222a, 4322a, 4422a, 4522a are passed through the insulating tubes 1021a, 1022a, 1023a, 1024a, 1025a from the other end toward the one end and are drawn to extend in the direction of the bulb axis to project from the one end of the insulating tubes 1021a, 1022a, 1023a, 1024a, 1025a; moreover, the vertical lead parts 4121a, 4221a, 4321a, 4421 a, 4521 a extend in directions perpendicular to the bulb axis, by which means the filaments 411, 421, 431, 441, 451 are installed on the insulating support 10 without contacting the insulating tubes 1021a, 1022a, 1023a, 1024a, 1025a. For the leads 412b, 422b, 432b, 442b, 452b connected to the other end of the filaments 411, 421, 431, 441, 451, the tips of the horizontal lead parts 4122b, 4222b, 4322b, 4422b, 4522b are passed through the insulating tubes 1021b, 1022b, 1023b, 1024b, 1025b from the one end toward the other end and are drawn to extend in the direction of the bulb axis to project from the other end of the insulating tubes 1021b, 1022b, 1023b, 1024b, 1025b; moreover, the vertical lead parts 4121b, 4221b, 4321b, 4421b, 4521b extend in directions perpendicular to the bulb axis, by which means the filaments 411, 421, 431, 441, 451 are installed on the insulating support 10 without contacting the insulating tubes 1021 b, 1022b, 1023b, 1024b, 1025b. Because the leads connected to the filament assemblies 41, 42, 43, 44, 45 pass through their individual insulating tubes, they do not short circuit each other.

Now, using the filament lamp 1 of this embodiment of the invention, basically, the same results as those of the filament lamp 1 of the invention of the first embodiment can be anticipated. Moreover, it is easier to manufacture the insulating support 10 than that of the insulating support 9 of the first embodiment, and so it is possible to reduce the costs required to manufacture the insulating support.

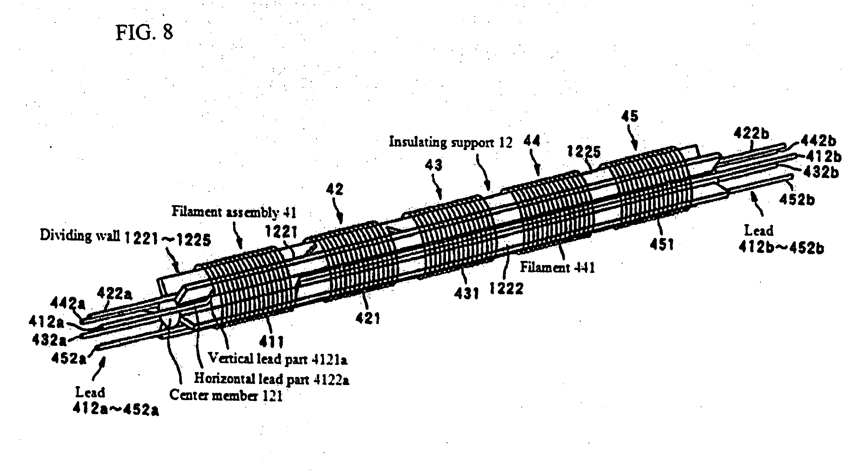

The third embodiment of this invention is explained below using Fig. 8.

Fig. 8 is a perspective view showing the construction of the light emitting area comprising the filament assemblies 41, 42, 43, 44, and 45 and the insulating support 12 of the filament lamp 1 of this embodiment of the invention. The filament lamp 1 of this embodiment becomes possible by means of applying a light emitting area comprising the filament assemblies and insulating support shown in Fig. 8 in place of the light emitting area comprising the filament assemblies and insulating support shown in Fig. 1.

As shown in Fig. 8, the light emitting area that comprises the filament assemblies and the insulating support of the filament lamp 1 has the same construction as shown in Fig. 2 except for the use of the insulating support 12 that has a construction in which dividing walls 1221, 1222, 1223, 1224, 1225 extend along the bulb axis and radiate in the radial direction of the filament assemblies 41, 42, 43, 44, 45.

The insulating support 12 is formed with multiple dividing walls 1221, 1222, 1223, 1224, 1225 that extend in the radial direction of filaments 411, 421, 431, 441, 451 and extend along the bulb axis, dividing space in the circumferential direction, and that are connected to a center member 121 that is formed in a round shape in a cross section in the radial direction and extends along the bulb axis. Such an insulating support 12 has a number of lead locations formed by the adjacent pair of dividing walls 1221, 1222 and the center member 121, the adjacent pair of dividing walls 1222, 1223 and the center member 121, the adjacent pair of dividing walls 1223, 1224 and the center member 121, the adjacent pair of dividing walls 1224, 1225 and the center member 121, and the adjacent pair of dividing walls 1225, 1221 and the center member 121, equal to the number of filament assemblies; the diameter of the virtual circle formed by joining the apices of the multiple dividing walls 1221, 1222, 1223, 1224, 1225 approximately matches the filament diameter. The insulating support 12 can be given the desired shape by machining a rod of insulating material, such as quartz glass, for example, or filling a mold with a molten fluid such as molten quartz glass, then cooling the molten fluid.

For the filament assemblies 41, 42, 43, 44, 45, when the center member 121 is in place on the same axis as the filaments 411, 421, 431, 441, 451, the paired filament leads 412a 412b; 422a, 422b; 531a, 531b; 442a, 442b; and 452a, 452b are placed separately in the same lead layout regions and installed in the insulating support 12 so that there is no short circuiting between them.

To explain in detail, one set of leads 412a, 422a, 432a, 442a, 452a that are connected to one end of the filaments 411, 421, 431, 441, 451 is placed so that the vertical lead parts 4121a, 4221a, 4321a, 4421a, 4521a extend toward the insulating support 12 in a direction perpendicular to the bulb axis and the horizontal lead parts 4122a, 4222a, 4322a, 4422a, 4522a placed in the lead layout region between pairs of adjacent dividing walls extend along the bulb axis and project from one end of the insulating support 12. The other set of leads 412b, 422b, 432b, 442b, 452b that are connected to the other end of the filaments 411, 421, 431, 441, 451 is placed so that the vertical lead parts 4121b, 4221b, 4321b, 4421b, 4521b extend toward the insulating support 12 in a direction perpendicular to the bulb axis and the horizontal lead parts 4122b, 4222b, 4322b, 4422b, 4522b placed in the same lead layout regions as the one set of leads 412a, 422a, 432a, 442a, 452a, separated by gaps that correspond to the lengths of the filaments 411, 421, 431, 441, 451, extend along the bulb axis, through the lead layout regions parallel to the dividing walls 1221, 1222, 1223, 1224, 1225, and project from the other end of the insulating support 12.

As stated above, using the filament lamp 1 of this embodiment of the invention, basically, the same results as those of the filament lamp 1 of the first embodiment can be anticipated. Moreover, because the filaments 411, 421, 431, 441, 451 are in contact with and supported by the dividing walls 1221, 1222, 1223, 1224, 1225, it is possible to place the filaments 411, 421, 431, 441, 451 in the desired positions with high precision, and it is possible to avoid drooping in the vertical direction by the filaments 411, 421, 431, 441, 451.

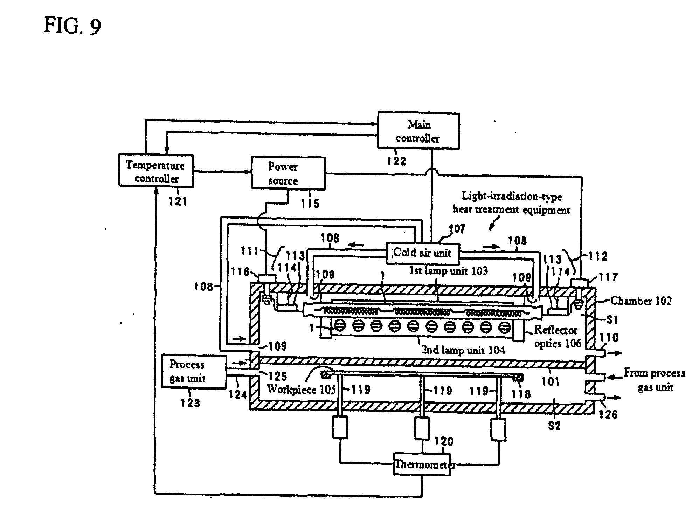

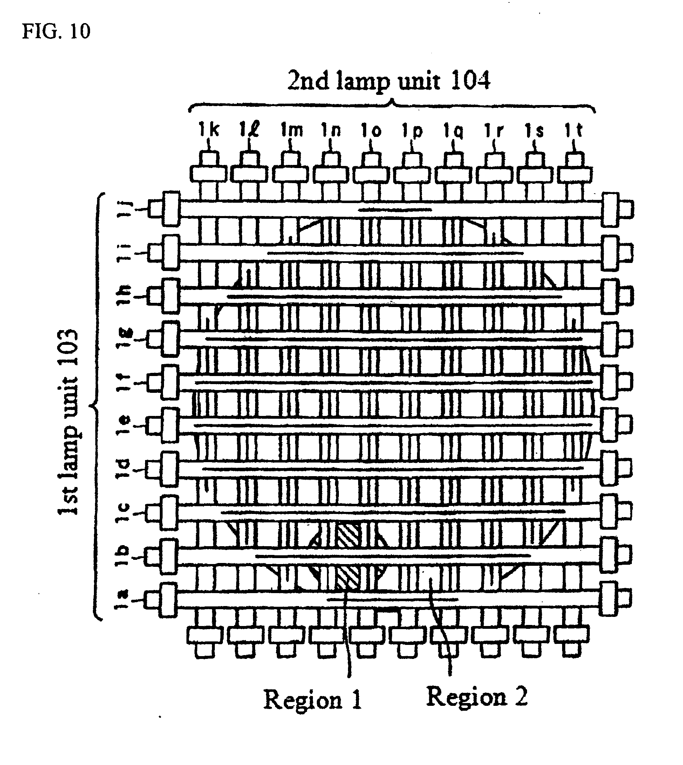

Next, the fourth embodiment of this invention is explained using Figs. 9 & 10.

Fig. 9 is a front cross section showing the light irradiation type heat-treatment device of this embodiment. Fig. 10 is a plan view showing the first lamp unit 103 and the second lamp unit 104 of Fig. 9. The light irradiation type heat-treatment device 100 is comprised of the filament lamps 1 of any of the first through the third embodiment.

As shown in Fig. 9, this light irradiation type heat-treatment device 100 has a chamber 102 that is divided by a quartz window 101 into a lamp unit accommodation space S1 and a heat treatment space S2. Heat treatment of an article 105 to be treated is performed by irradiating the article 105 to be treated, which is located in the heat treatment space S2, with light that passes through the quartz window 101 after it is emitted by the first lamp unit 103 and the second lamp unit 104.

The first lamp unit 103 and the second lamp unit 104 face each other within the lamp unit accommodation space S1; each is constituted by, for example, ten filament lamps 1 arranged parallel to each other and separated by gaps of a specified size. As shown Fig. 9, the direction of the bulb axes of the filament lamps 1 that make up the first lamp unit 103 intersects the direction of the bulb axes of the filament lamps 1 that make up the second lamp unit 104. Now, it is not necessary to use two stages of lamp units as shown in Fig. 9; a construction with only one lamp unit stage is also acceptable.

Reflecting optics 106 are located above the first lamp unit 103. The reflecting optics 106 can have a structure of gold coated onto a base material of oxygen-free copper, for example, and the cross section of the reflecting surface has a shape such as a partial circle, a partial ellipse, a partial parabola, or a flat plate. Light that is emitted upward by the first lamp unit 103 and the second lamp unit 104 is reflected toward the article 105 to be treated by the reflecting optics 106. In other words, the light emitted by the first lamp unit 103 and the second lamp unit 104 is reflected by the reflecting optics 106 and then irradiates the article 105 to be treated.

Cold air from the cold air unit 107 is introduced into the lamp unit accommodation space S1 through the jets 109 of the cold air supply nozzles 108 installed in the chamber 102. The cold air introduced into the lamp unit accommodation space S1 is blown onto the filament lamps 1 of the first lamp unit 103 and the second lamp unit 104, cooling the bulbs that make up the filament lamps 1. Here, the seal areas of the filament lamps 1 have a lower resistance to heat than other parts. It is desirable, therefore, that the jets 109 of the cold air supply nozzles be directed toward the seal areas of the filament lamps 1, and that they be constituted to give priority to cooling the seal areas of the filament lamps 1.

The cold air that is blown on the filament lamps 1 and reaches a high temperature by means of heat exchange is exhausted by way of the cold air exhaust port installed in the chamber 102. Now, consideration has been given so that the flow of cold air does not, conversely, heat the filament lamps 1 after it has reached a high temperature by means of heat exchange. The flow of this cold air is set so that it cools the reflecting optics 106 at the same time. Now, it is not necessary to set the flow of air to cool the reflecting optics 106 at the same time in the event that the reflecting optics are water-cooled by a water-cooling mechanism, illustration of which has been omitted.

Incidentally, there may be an accumulation of heat in the quartz window 101, due to radiant heat from the heated article 105 to be treated. Secondary thermal radiation from the quartz window 101 that has accumulated heat sometimes has an undesirable effect of heating the article 105 to be treated. In this case, there may be such problems as redundancy of temperature control of the article 105 to be treated (for example, overshoot such that the temperature of the article 105 to be treated is hotter than the set temperature) or reduced temperature uniformity in the article 105 to be treated due to the temperature of the quartz window 101 that has accumulated heat. Moreover, it becomes difficult to increase the rate of cooling of the article 105 to be treated. To suppress these problems, therefore, it is desirable to install a jet 109 of a cold air supply nozzle 108 in the vicinity of the quartz window 101, as shown in figure 9, and to cool the quartz window 101 with cold air from the cold air unit 107.

Each filament lamp 1 of the first lamp unit 103 is supported by a pair of first fixed stages 111, 112. The first fixed stages 111, 112 comprise conductive stages 113 that are formed of conductive material and holding stages 114 that are formed of an insulating material, such as a ceramic. The holding stages 114 are mounted on the inner wall of the chamber 102 and hold the conductive stages 113. Taking the number of filament lamps 1 in the first lamp unit 103 as n1 and the number of filament assemblies per filament lamp 1 as ml, the number of paired sets of first fixed stages 111, 112 is n1 x m1 sets, in the event that power is supplied independently to all of the filament assemblies. Each filament lamp 1 of the second lamp unit 104, on the other hand, is supported by second fixed stages. Like the first fixed stages 111, 112, the second fixed stages comprise conductive stages and holding stages. Taking the number of filament lamps 1 in the second lamp unit 104 as n2 and the number of filament assemblies per filament lamp 1 as m2, the number of paired sets of second fixed stages is n2 x m2 sets, in the event that power is supplied independently to all of the filament assemblies.

Pairs of electrical power-supply ports 116, 117 are installed in the chamber 102 and are connected to power feed wires from the power supply of the power source 115. A single pair of power-supply ports 116, 117 is shown in Fig. 9, but the number of power-supply ports is determined by the number of filament lamps 1 and the number of filament assemblies in each filament lamp 1. In Fig. 9, the power-supply ports 116, 117 are electrically connected to the conductive stages 113 of the first lamp fixed stages 111, 112. The conductive stages 113 of the first lamp fixed stages 111, 112 are electrically connected to the external leads, for example. By means of such a construction, it becomes possible to feed power from the power supply in the power source 115 to a filament assembly of one filament lamp in the first lamp unit 103. Now, the other filament assemblies of that filament lamp 1, the filaments of the other filament lamps 1 in the first lamp unit 103, and the filaments of each filament lamp 1 in the second lamp unit 104 are similarly connected electrically to other paired power-supply ports.

Moreover, a treatment stage 118 to which the article 105 to be treated is fixed is installed in the heat-treatment space S2. If the article 105 to be treated is a semiconductor wafer, for example, the treatment stage 118 is a thin, ring-shaped plate of a high-melting-point metal, such as molybdenum, tungsten, or tantalum or a ceramic, such as silicon carbide (SiC), or quartz or silicon (Si). Preferably, the treatment stage has a guard-ring structure formed with steps to hold the semiconductor wafer within a round opening. The semiconductor wafer, that is the article 105 to be treated, is placed so that the semiconductor wafer is held in the round opening of the round guard ring and supported by the steps. The treatment stage 118 is itself heated by light irradiation and provides supplementary heat to the outer edge of the semiconductor wafer that faces it; this compensates for the heat radiated from the outer edge of the semiconductor wafer. By this means, temperature drops at the periphery of the semiconductor wafer due to heat radiated from the outer edge of the semiconductor wafer can be suppressed.

On the reverse side from the light-irradiation side of the article 105 to be treated that is set in the treatment stage 118, there are temperature measurement areas 119 in contact with or close to the article 105 to be treated. The temperature measurement areas 119 monitor the temperature distribution of the article 105 to be treated; their number and placement depends on the dimensions of the article 105 to be treated. Such things as thermocouples or radiant heat thermometers, for example, can be used as the temperature measurement areas 119. The temperature information monitored by the temperature measurement areas 119 is transmitted to the thermometer 120. On the basis of the temperature information transmitted by the temperature measurement areas 119, the thermometer 120 calculates the temperatures at the points measured by each temperature measurement area 119 and sends the calculated temperature information to the main controller 122 by way of the temperature controller 121. Based on the temperature information for the points measured on the article 105 to be treated, the main controller 122 sends the temperature controller 121 commands to make designated temperatures on the article 105 to be treated to be uniform. On the basis of these commands, the temperature controller 121 controls the power supplied from the power source 115 to each filament assembly of the filament lamps 1. For example, if the main controller 121 receives temperature information from the temperature controller 121 to the effect that the temperature of a certain measured point is lower than the specified temperature, it sends the temperature controller 121 a command to increase the amount of power fed to the filament assembly next to the measured point, so that the light emitted from the light emitting area of that filament assembly will increase. Based on the command transmitted from the main controller 122, the temperature controller 121 will increase the power supplied from the power source 115 to the power-supply ports 116, 117 connected to that filament assembly.

While the filament lamps 1 in the first and second lamp units 103, 104 are lit, the main controller 122 sends commands to the cold air unit 107 so that the bulbs and the quartz window 101 will not reach a high temperature. Depending on the type of heat treatment, moreover, a process gas unit 123 that introduces and exhausts process gases can be connected to the heat-treatment space S2. If a hot oxidation process is to be conducted, for example, a process gas unit 123 is connected to the heat-treatment space S2 to introduce and exhaust oxygen gas and a purge gas (such as nitrogen gas) to purge the heat-treatment space S2. The process gases and purge gases from the process gas unit 123 are introduced into the heat-treatment space S2 from the jet 125 of the gas supply nozzle 124 installed in the chamber 102. They are exhausted through the exhaust port 126.

Using the light irradiation type heat-treatment device 100 described above, it is possible to achieve the following effects. Within the filament lamps 1 mounted in the lamp units 103, 104 that are the light source of the light irradiation type heat-treatment device 100, the light emitting areas comprise the filament assemblies and insulating supports shown in the first through the third embodiments above, and the power supplied to each filament can be controlled independently, so that setting the light-intensity distribution can be regulated even in the bulb axis direction of the bulbs. Therefore, the treatment-intensity distribution on the surface of the article 105 to be treated can also be set with high precision in two dimensions. For example, for a small special region (such as special region 1 in Fig. 10) that is shorter than the light emitting length of the filament lamps used in the light source of the light irradiation type heat-treatment device of the prior art, it is possible to set the irradiation intensity for a special region (region 1) and limit it to that special region (region 1). That is, it is possible to set the irradiation-intensity distribution to suit the respective characteristics of both the special region (region 1) and the other region (region 2 in Fig. 10). Therefore, it is possible to control the temperatures of the special region (region) and the other region (region 2) so that they are uniform Similarly, it is possible to suppress the occurrence of localized temperature distributions on the article 105 to be treated, and to obtain a uniform temperature distribution across the full article 105 to be treated.

Moreover, because filament lamps 1 which have very fine and closely spaced filament leads in the bulbs are used in the light irradiation type heat-treatment device of this invention, the influence of the gaps between filaments, which do not emit light, can be reduced. Further, the space holding the lamp units 103, 104 that comprise multiple tubular filament lamps 1 can be kept small in the direction of the height of the light irradiation type heat-treatment device 100, and so, the size of the light irradiation type heat-treatment device 100 can be reduced.

By means of the filament lamps 1 that are mounted in this light irradiation type heat-treatment device 100, as was explained in connection with the first through the third embodiments of the invention, the insulating support located inside each of the filaments supports the leads of that filament so that it does not short circuit with the leads of other filaments. Even in a construction with multiple filament assemblies within a bulb, therefore, leads are not located outside the filaments, and so it is easy to obtain the desired light-irradiation-intensity distribution with the light emitted by the filaments not blocked by the leads, while assuring insulation between the leads.

Now, the light irradiation type heat-treatment device of this invention has been explained in the case where lamp units 103, 104 comprised of multiple, parallel filament lamps 1 are used as the light source, but constructions with multiple lamp units is not always necessary; a light source constituted with a single filament lamp 1 may also acceptable in certain circumstances.

Moreover, the articles to be treated to receive heat treatment in the light irradiation type heat-treatment device of this invention are not limited to semiconductor wafers; the equipment can be applied to crystalline silicon substrates or glass or ceramic substrates for solar cell panels, or glass substrates for liquid-crystal displays, and so on.

In particular, rectangular substrates of various materials are often used for solar cell panels, and most of the light irradiation type heat-treatment devices used for heat treatment of such articles to be treated are constructed to move rectangular substrates horizontally and to provide heat treatment by irradiation with a band of light, either by means of a single filament lamp that is placed so that the bulb axis extends in a direction perpendicular to the direction of substrate movement, or by means of multiple filament lamps arrayed to provide heat treatment by irradiating with a band of light. Using a filament lamp 1 having four or more filament assemblies, in such cases, makes it possible, while compensating for the temperature drop in the areas parallel to the direction of substrate motion (i.e., at the two ends of the band), to regulate the irradiation-intensity distribution on the center of the substrate (at the center of the band), and thus to assure more precise temperature control.

## Claims

1. A filament lamp, comprising:
a bulb which has a hermetically sealed portion on at least one end;
multiple filament assemblies, each filament assembly comprising a coiled filament and connected leads to supply power to that filament, within said bulb, the filament assemblies being sequentially arranged in the axial direction of the bulb, the leads of each filament being electrically connected to multiple conductive parts set in the sealed portions, and power being independently suppliable to each of the filaments; wherein leads of individual filament assemblies are inserted through the inside of the coiled filaments.

2. A filament lamp as described in claim 1, in which an insulating support extends along a central axis of the filament within the coiled filament, and wherein multiple passages are formed in the insulating support through which the leads of the filament assemblies pass.

3. A filament lamp as described in claim 1 or 2, wherein a rod-shaped sealing insulator is located in the hermetic seal area, wherein multiple conductive parts are arrayed at intervals on the periphery of the sealing insulator, and wherein the bulb and the sealing insulator are hermetically sealed with conductive parts located between them.

4. Light irradiation type heat treatment device comprising a light source,
said light source having at least one filament lamp as claimed in any one of claims 1 to 3.

5. Light irradiation type heat treatment device according to claim 4, wherein multiple filament lamps of said plurality of filament lamps are arrayed in parallel and form a lamp unit.

6. Light irradiation type heat treatment device according to claim 4 or 5, wherein multiple filament lamps are arranged in two stages disposed one above the other and in which the lamps of one stage extend crosswise to the lamps of the other stage.
